(19) Europäisches Patentamt / European Patent Office / Office européen des brevets

(11) **EP 2 091 149 A1**

(12) **DEMANDE DE BREVET EUROPEEN**

(43) Date de publication:
**19.08.2009 Bulletin 2009/34**

(51) Int Cl.:
***H03H 17/06*** *(2006.01)*

(21) Numéro de dépôt: **08151565.2**

(22) Date de dépôt: **18.02.2008**

(84) Etats contractants désignés:
**AT BE BG CH CY CZ DE DK EE ES FI FR GB GR HR HU IE IS IT LI LT LU LV MC MT NL NO PL PT RO SE SI SK TR**
Etats d'extension désignés:
**AL BA MK RS**

(71) Demandeur: STMicroelectronics N.V.
**1118 BH Schiphol Airport Amsterdam (NL)**

(72) Inventeurs:
• **Dubouloz, Samuel**
**74100 ANNEMASSE (FR)**
• **Hue, Antoine**
**01630 SAINT GENIS POUILLY (FR)**

(74) Mandataire: **Zapalowicz, Francis**
**Bureau Casalonga & Josse**
**Bayerstrasse 71/73**
**80335 München (DE)**

(54) **Procédé et dispositif de conversion descendante de fréquence d'échantillonnage d'un signal numérique.**

(57) Procédé de conversion de fréquence d'échantillonnage d'un signal numérique échantillonné à une première fréquence d'échantillonnage, caractérisé par le fait qu'il comprend une réception (20) d'échantillons d'entrée ($x_k$) du signal numérique, une élaboration (21, 22) d'échantillons de sortie correspondant ($y_n$) à une deuxième fréquence d'échantillonnage ($F_i$) à partir des échantillons d'entrée et d'un filtre d'interpolation, la première fréquence d'échantillonnage ($F_s$) étant plus grande que la deuxième fréquence d'échantillonnage ($F_i$) dans un rapport ($F_s/F_i$) quelconque, et une délivrance (23) desdits échantillons de sortie, ladite élaboration comportant pour chaque échantillon d'entrée courant la mise à jour (22) des valeurs courantes de N échantillons de sortie successifs avec N contributions respectivement calculées (21) à partir de la valeur de cet échantillon d'entrée courant pondérée par les valeurs de N coefficients du filtre (hl, ...hN) associés à cet échantillon d'entrée courant, ce nombre N étant fixé et identique pour tous les échantillons d'entrée quelle que soit la valeur dudit rapport.

FIG.2

**Description**

L'invention concerne notamment la conversion descendante de fréquence d'échantillonnage d'un signal numérique, encore appelée « sous-échantillonnage » ou « décimation », dans un rapport de conversion de fréquence, par exemple non entier, entre la fréquence d'échantillonnage d'entrée (qui est la plus élevée) et la fréquence d'échantillonnage de sortie (qui est plus faible).

L'invention s'applique avantageusement mais non limitativement aux systèmes de communication sans fil et, plus particulièrement, aux plates-formes de réception multi-normes qui requièrent de multiples fréquences d'échantillonnage différentes.

On peut citer à cet égard les normes WiMAX (acronyme pour « Worldwide Interoperability for Microwave Access »), qui est une famille de normes définissant les connexions à haut débit par voie hertzienne destinées principalement à des architectures point-multipoints. Les normes WiMAX comportent notamment les normes de la famille 802.16.

On peut également citer les normes de la famille 802.11, également connues sous le nom de « normes WiFi ». La norme IEEE 802.11 est une norme internationale décrivant les caractéristiques d'un réseau local sans fil (WLAN) capable de communiquer à haut débit sur un rayon de plusieurs dizaines de mètres en intérieur.

La réalisation d'un récepteur capable d'être compatible avec plusieurs normes de transmission nécessite de pouvoir traiter de multiples fréquences d'échantillonnage du signal numérique. Or, en raison notamment des contraintes de synthèse de fréquence, la fréquence d'échantillonnage du signal au niveau de l'étage de conversion analogique/numérique n'est pas nécessairement flexible.

Par ailleurs, les convertisseurs analogiques/numériques de faible puissance, c'est-à-dire de faible consommation de courant, utilisent de plus en plus un suréchantillonnage pour réduire le nombre requis de niveau de quantification tout en maintenant un bon rapport signal/bruit de quantification. Ce type de convertisseur analogique/numérique requiert donc de filtrer le bruit de quantification en dehors de la bande utile du signal et de réduire la fréquence d'échantillonnage à une valeur inférieure à celle à laquelle le signal numérique est traité. De ce fait, les dispositifs classiques de conversion de fréquence d'échantillonnage requièrent un certain nombre de multiplications à haute fréquence, ce qui conduit à une complexité élevée du dispositif et par conséquent à une consommation de puissance importante.

Par ailleurs, il est nécessaire de pouvoir effectuer une conversion de fréquence d'échantillonnage dans un rapport de conversion non entier, de façon à être capable de fournir une fréquence d'échantillonnage à la fois compatible avec la norme de transmission requise et avec la fréquence d'échantillonnage de l'étage de conversion analogique/numérique.

Plusieurs solutions existent pour effectuer une conversion de fréquence d'échantillonnage avec un rapport de conversion non entier.

Une première solution consiste à convertir le signal numérique en un signal analogique, en utilisant un convertisseur numérique/analogique, puis de filtrer le signal analogique et ensuite de le reconvertir en un signal numérique avec la fréquence d'échantillonnage désirée. Cela étant, une telle solution n'est guère satisfaisante car elle conduit à un bruit important de conversion et il n'y a guère de moyen satisfaisant pour générer le signal d'horloge du convertisseur analogique/numérique permettant la reconversion du signal analogique à la fréquence d'échantillonnage désirée.

Une autre solution consiste à suréchantillonner le signal numérique par un facteur S, à filtrer à la fois les composantes de repliement de signal et le bruit de quantification, et à effectuer ensuite une décimation (conversion descendante de fréquence d'échantillonnage), par un facteur M. On obtient alors une conversion de fréquence d'échantillonnage dans un rapport rationnel S/M. Cependant, une telle solution n'est pas vraiment flexible. En effet, seuls un petit nombre de rapports de conversion peuvent être envisagés, car chaque rapport de conversion nécessite la réalisation d'un filtre. En outre, seuls des rapports rationnels de conversion de fréquence (c'est-à-dire des rapports dont le numérateur et le dénominateur sont entiers) peuvent être utilisés. En outre, les fréquences de fonctionnement étant actuellement déjà très hautes, il est particulièrement difficile de réaliser un suréchantillonnage sans augmenter la consommation de puissance et la complexité globale du dispositif.

Une autre solution réside dans une interpolation, c'est-à-dire dans un calcul de nouveaux échantillons (échantillons interpolés) à partir des échantillons d'entrée en utilisant un filtre d'interpolation. Cependant, de telles solutions sont actuellement compliquées et nécessitent des ressources de mémoire importantes ainsi que des bus haute vitesse pour stocker tous les coefficients du filtre en fonction de l'écart temporel entre un échantillon interpolé et les échantillons d'entrée qui servent à calculer cet échantillon interpolé.

Par ailleurs, dans certaines applications, on utilise avantageusement pour les étages de conversion analogique/numérique générant le signal numérique dont on veut convertir la fréquence d'échantillonnage, des étages du type delta-sigma. De tels convertisseurs analogiques/numériques de type delta-sigma sont particulièrement intéressants car ils permettent de coder le signal numérique sur un faible nombre de bits tout en rejetant le bruit de quantification en dehors de la bande utile du signal. Or, les solutions actuelles de conversion descendante (décimation) de fréquence d'échantillonnage ne sont pas adaptées à des signaux suréchantillonnés provenant de convertisseurs du type delta-sigma car les solutions actuelles n'effectuent qu'un filtrage des composantes de repliement de signal mais non du bruit de quantification.

Selon un mode de mise en oeuvre et de réalisation, il est proposé notamment un procédé et un dispositif de conversion de fréquence d'échantillonnage d'un signal numérique permettant d'effectuer une conversion de fréquence descendante dans un rapport entier ou non entier, rationnel ou irrationnel, qui soit ajustable, ce qui permet de s'adapter très aisément aux plates-formes de réception multi-normes de transmission.

Il est également proposé selon un mode de mise en oeuvre et de réalisation, un procédé et un dispositif de conversion de fréquence d'échantillonnage utilisant un filtre d'interpolation avec une faible complexité de réalisation et de mise en oeuvre.

Il est également proposé selon un autre mode de mise en oeuvre et de réalisation, un procédé et un dispositif de conversion de fréquence d'échantillonnage qui permettent un filtrage non seulement des répliques du signal, mais également de toute composante du signal qui serait repliée dans la bande utile du signal après la conversion de fréquence d'échantillonnage, ce qui permet en particulier de filtrer le bruit de quantification issu par exemple d'un étage de conversion analogique/numérique.

Il est également proposé selon un autre mode de mise en oeuvre et de réalisation, un procédé et un dispositif de conversion de fréquence d'échantillonnage dans lequel on n'effectue pas d'approximation sur la forme du filtre, ce qui permet de prendre en compte des coefficients de filtrage exacts.

Selon un aspect, il est ainsi proposé un procédé de conversion de fréquence d'échantillonnage d'un signal numérique échantillonné à une première fréquence d'échantillonnage, le procédé comprenant :

- une réception d'échantillons d'entrée du signal numérique,
- une élaboration d'échantillons de sortie correspondant à une deuxième fréquence d'échantillonnage à partir des échantillons d'entrée et d'un filtre d'interpolation, la première fréquence d'échantillonnage étant plus grande que la deuxième fréquence d'échantillonnage , et
- une délivrance desdits échantillons de sortie.

Selon cet aspect, ladite élaboration des échantillons de sortie comporte pour chaque échantillon d'entrée courant la mise à jour des valeurs courantes de N échantillons de sortie successifs avec N contributions, respectivement calculées à partir de la valeur de cet échantillon d'entrée courant, pondérée par les valeurs de N coefficients du filtre associés à cet échantillon d'entrée courant, ce nombre N étant fixé et identique pour les échantillons d'entrée, quelle que soit la valeur du rapport de conversion entre les deux fréquences, qui peut être quelconque, par exemple entier ou non entier.

En d'autres termes, selon cette approche, et contrairement aux solutions existantes dans lesquelles la réponse impulsionnelle du filtre est basée sur une première période temporelle correspondant à la première fréquence d'échantillonnage (ce qui implique qu'un échantillon de sortie doit être calculé avec un nombre fixé d'échantillons d'entrée), le filtre d'interpolation est basé ici sur la deuxième période temporelle correspondant à la deuxième fréquence d'échantillonnage, ce qui signifie qu'un échantillon d'entrée contribue à la détermination des valeurs d'un nombre fixé d'échantillons de sortie. Et ce nombre fixé est indépendant du rapport de conversion, ce qui n'est pas le cas pour les solutions existantes qui impliquent par conséquent un stockage de coefficients de filtre pour chaque rapport de conversion envisagé.

Par contre, si chaque échantillon d'entrée courant contribue à la détermination des valeurs d'un nombre fixé d'échantillons de sortie, un échantillon de sortie peut recevoir un nombre de contributions différent du nombre de contributions destinées à un autre échantillon de sortie.

Ainsi, on peut filtrer, non seulement les répliques du signal échantillonné, mais également toute composante qui serait repliée dans la bande utile après conversion de la fréquence d'échantillonnage.

Même si la valeur du rapport de conversion peut être quelconque, il est proposé un mode de mise en oeuvre particulièrement intéressant pour des valeurs non entières, rationnelles ou irrationnelles du rapport de conversion, car ceci apporte notamment une solution et une réalisation matérielle simples à mettre à oeuvre même pour des rapports de conversion non entiers.

Par ailleurs, les coefficients du filtre peuvent être par exemple avantageusement calculés « en ligne », c'està-dire au fur et à mesure qu'ils sont nécessaires pour le calcul des contributions.

Selon un mode de mise en oeuvre, on délivre un échantillon de sortie dont la valeur a été mise à jour avec une contribution provenant d'un échantillon d'entrée courant, si cet échantillon de sortie ne doit pas recevoir de contribution provenant de l'échantillon d'entrée suivant. La valeur effective de cet échantillon de sortie délivré est alors ladite valeur mise à jour avec la contribution provenant de l'échantillon d'entrée courant.

Selon un mode de mise en oeuvre, la largeur de la réponse impulsionnelle du filtre d'interpolation fixe la valeur du nombre N. Ainsi, par exemple, on choisit un filtre d'interpolation dont la largeur de la réponse impulsionnelle est égale au produit d'un coefficient multiplicateur par la deuxième période temporelle correspondant à la deuxième fréquence d'échantillonnage, et on fixe la valeur de N à une valeur égale à la partie entière supérieure du coefficient multiplicateur.

Selon un exemple de mise en oeuvre, lors de la mise à jour des valeurs des échantillons de sortie de rangs n à n+N-1, on affecte respectivement à ces N échantillons de sortie N moyens de stockage de rangs $r_1$ à $r_N$ dans chacun desquels on accumule, pour l'échantillon de sortie considéré, les différentes contributions issues des différents échantillons d'entrée, et la délivrance de l'échantillon de sortie de rang n avec sa valeur effective comporte
la délivrance de la valeur contenue dans le moyen de stockage de rang $r_1$,
l'affectation des registres de rangs $r_1$ à $r_{N-1}$ aux échantillons de sortie de rangs n+1 à n+N-1,
l'affectation du registre de rang $r_N$ à l'échantillon de sortie de rang n+N, et
l'initialisation du registre de rang $r_N$ à une valeur d'initialisation choisie, par exemple la valeur nulle. Un tel exemple de mise en oeuvre est particulièrement simple à réaliser.

Selon un mode de mise en oeuvre, on reçoit les échantillons d'entrée au rythme des fronts d'un signal d'horloge ayant une fréquence égale à la première fréquence d'échantillonnage, et on élabore les échantillons de sortie au rythme des fronts de ce signal d'horloge. Par contre, on délivre les échantillons de sortie sur certains seulement des fronts du signal d'horloge. Ceci dépend en particulier du nombre de contributions nécessaires pour l'élaboration de la valeur effective d'un échantillon de sortie. Ainsi, la fréquence de délivrance des échantillons de sortie peut être différente de la deuxième fréquence d'échantillonnage. Cela étant, ces échantillons de sortie délivrés correspondent effectivement à un échantillonnage du signal numérique à ladite deuxième fréquence d'échantillonnage.

On sélectionne avantageusement la valeur du rapport de conversion de fréquence d'échantillonnage parmi un jeu de valeurs correspondant à des valeurs de deuxième fréquence d'échantillonnage compatibles avec plusieurs normes différentes, par exemple les normes WiMAX ou WiFi.

On choisit également avantageusement un filtre d'interpolation dont la courbe de réponse amplitude/fréquence présente des zéros aux fréquences multiples de la deuxième fréquence d'échantillonnage.

Ceci permet d'avoir une bonne atténuation dans des bandes de fréquences se situant autour des multiples de la seconde fréquence d'échantillonnage. Ceci est particulièrement intéressant lorsque la conversion analogique/numérique du signal est du type delta-sigma. En effet, un tel filtre permet de filtrer efficacement le bruit de quantification.

On peut par exemple utiliser un filtre d'interpolation dont la courbe de réponse amplitude/fréquence présente une forme du type sinc2.cos (sinc2 désigne la fonction sinus cardinal élevé au carré). Ceci permet d'obtenir une atténuation d'au moins 60 dB dans les bandes mentionnées ci-dessus.

Selon un mode de mise en oeuvre, le calcul des N contributions d'un échantillon d'entrée courant comporte :

- la détermination de la position temporelle de cet échantillon d'entrée courant par rapport aux N instants temporels, dits « instants temporels d'interpolation », mutuellement espacés de la deuxième période temporelle correspondant à la deuxième fréquence d'échantillonnage et respectivement associés aux N échantillons de sortie mis à jour, et
- la prise en compte de ladite position temporelle dans la détermination des valeurs des N coefficients du filtre.

Plus précisément et à titre d'exemple, si les échantillons d'entrée arrivent à des premiers instants temporels, la détermination de la position temporelle d'un échantillon d'entrée courant par rapport auxdits N instants temporels d'interpolation comprend la détermination d'un intervalle temporel entre le premier instant temporel associé à cet échantillon d'entrée courant et l'un des N instants temporels d'interpolation, et la détermination des autres intervalles temporels entre ledit premier instants et les N-1 autres instants temporels d'interpolation à partir dudit intervalle temporel, et les valeurs des N coefficients du filtre correspondent respectivement aux valeurs de la réponse impulsionnelle du filtre à ces N intervalles temporels.

Par ailleurs, le fait de baser la réponse impulsionnelle du filtre d'interpolation sur la valeur de la deuxième période temporelle, et le fait d'utiliser cette deuxième période temporelle comme base de référence temporelle pour l'interpolation, rendent possible la détermination des valeurs des coefficients du filtre à partir d'une fonction dudit intervalle temporel.

Cette fonction peut comprendre par exemple au moins une zone linéaire, ce qui est le cas lorsque le filtre a une courbe de réponse amplitude/fréquence présentant une forme du type sinc2.cos.

Ceci permet alors une importante réduction de la complexité de réalisation.

En effet, selon un mode de mise en oeuvre, la valeur dudit intervalle temporel varie entre 0 et 1 et on définit un intervalle temporel auxiliaire à partir de cet intervalle temporel dont la valeur est égale à celle dudit intervalle temporel rapportée dans la plage [0 ;0,25[, et le calcul d'une contribution d'un échantillon d'entrée courant comporte une seule multiplication de la valeur de cet échantillon d'entrée avec la valeur dudit intervalle temporel auxiliaire.

Selon un autre aspect, il est également proposé un procédé de traitement d'un signal analogique, comportant une conversion analogique/numérique du signal analogique et un procédé de conversion de fréquence d'échantillonnage tel que défini précédemment, d'un signal numérique issu de ladite conversion analogique/numérique.

Ladite conversion analogique/numérique peut être du type delta-sigma.

Par ailleurs, le signal analogique peut être un signal choisi parmi plusieurs signaux respectivement compatibles avec plusieurs normes de transmission, par exemple la norme WiMAX ou WiFi.

Selon un autre aspect, il est également proposé un dispositif de conversion de fréquence d'échantillonnage d'un signal numérique échantillonné à une première fréquence d'échantillonnage.

Ce dispositif comprend

des moyens de réception aptes à recevoir des échantillons d'entrée du signal numérique,
des moyens d'élaboration aptes à élaborer les échantillons de sortie correspondant à une deuxième fréquence d'échantillonnage à partir des échantillons d'entrée et d'un filtre d'interpolation, la première fréquence d'échantillonnage étant plus grande que la deuxième fréquence d'échantillonnage, et
des moyens de sortie aptes à délivrer des échantillons de sortie ;
les moyens d'élaboration comprenant
des moyens de calcul aptes pour chaque échantillon d'entrée courant à calculer N contributions respectivement à partir de la valeur de cet échantillon d'entrée courant pondérée par les valeurs de N coefficients du filtre associés à cet échantillon d'entrée, ce nombre N étant fixé et identique pour tous les échantillons d'entrée quelle que soit la valeur du rapport de conversion entre les deux fréquences, et
des moyens de traitement aptes pour chaque échantillon d'entrée à mettre à jour les valeurs courantes de N échantillons de sortie successifs avec les N contributions.

Selon un mode de réalisation, les moyens d'élaboration comportent en outre des moyens de contrôle aptes à autoriser la délivrance d'un échantillon de sortie dont la valeur a été mise à jour avec une contribution provenant d'un échantillon d'entrée courant si cet échantillon de sortie ne doit pas recevoir de contribution provenant de l'échantillon d'entrée suivant, la valeur effective de cet échantillon de sortie délivré étant ladite valeur mise à jour avec la contribution provenant de l'échantillon d'entrée courant.

Selon un mode de réalisation, les moyens de traitement comportent

N entrées aptes à recevoir respectivement les N contributions d'un échantillon d'entrée courant,
N additionneurs possédant chacun une première entrée couplée à l'entrée correspondante des moyens de traitement et une deuxième entrée,
N multiplexeurs aptes à être commandés par les moyens de commande et possédant chacun une première entrée connectée à la sortie de l'additionneur correspondant et une deuxième entrée,
une chaîne de N registres possédant chacun une entrée couplée à la sortie du multiplexeur correspondant et une sortie couplée à la deuxième entrée de l'additionneur correspondant, la sortie du dernier registre de la chaîne étant couplée aux moyens de sortie et la sortie de chacun des autres registres étant couplée à la deuxième entrée du multiplexeur associé au registre suivant dans ladite chaîne,
un registre auxiliaire contenant une donnée de valeur nulle et couplée à la deuxième entrée du multiplexeur associé au premier registre de la chaîne.

Selon un mode de réalisation, les moyens de réception sont aptes à recevoir les échantillons d'entrée au rythme des fronts d'un signal d'horloge ayant une fréquence égale à la première fréquence d'échantillonnage et les moyens d'élaboration sont aptes à élaborer les échantillons de sortie au rythme des fronts dudit signal d'horloge et les moyens de sortie sont aptes à délivrer les échantillons de sortie sur certains seulement des fronts du signal d'horloge.

Selon un mode de réalisation, le dispositif peut comprendre en outre des moyens de sélection aptes à sélectionner la valeur dudit rapport parmi un jeu de valeurs correspondant à des valeurs de deuxièmes fréquences d'échantillonnage compatibles avec plusieurs normes différentes, par exemple les normes WiMax ou WiFi.

Selon un mode de réalisation, lesdits moyens de calcul comportent des premiers moyens aptes à déterminer la position temporelle d'un échantillon d'entrée courant par rapport aux N deuxièmes instants, dits instants temporels d'interpolation, respectivement associés aux N échantillons de sortie destinés à être mis à jour, et des deuxièmes moyens aptes à déterminer les valeurs des N coefficients du filtre à partir de ladite position temporelle.

Selon un mode de réalisation, les premiers moyens sont aptes à déterminer un intervalle temporel entre le premier instant associé à un échantillon d'entrée courant et l'un des N instants temporels d'interpolation, et à déterminer les autres intervalles temporels entre ledit premier instants et les N-1 autres instants temporels d'interpolation à partir dudit intervalle temporel, et les valeurs des N coefficients du filtre correspondent respectivement aux valeurs de la réponse impulsionnelle du filtre à ces N intervalles temporels.

Les deuxièmes moyens peuvent être aptes à déterminer chacun des N coefficients du filtre à partir d'une fonction dudit intervalle temporel, cette fonction pouvant être par exemple une fonction linéaire.

Dans ce cas, la valeur dudit intervalle temporel variant entre 0 et 1, les premiers moyens sont aptes à déterminer un intervalle temporel auxiliaire à partir de cet intervalle temporel dont la valeur est égale à celle dudit intervalle temporel rapportée dans la plage [0 ;0,25[, et les moyens de calcul comportent un seul multiplieur possédant une entrée couplée aux moyens d'entrée et une deuxième entrée couplée aux premiers moyens pour recevoir ledit intervalle temporel auxiliaire.

Selon un mode de réalisation, les moyens de calcul comportent en outre bloc comportant au moins un un additionneur, au moins un soustracteur et au moins un moyen de décalage de bits individuellement sélectionnables en fonction de la valeur de l'intervalle temporel.

Selon un autre aspect, il est également proposé un dispositif de traitement d'un signal analogique comportant une entrée pour recevoir le signal analogique, un convertisseur analogique/numérique couplé à ladite entrée, et un dispositif de conversion de fréquence d'échantillonnage tel que défini ci avant, dont les moyens d'entrée sont couplés à la sortie du convertisseur analogique/numérique.

Le convertisseur analogique/numérique peut être du type delta-sigma.

Selon un autre aspect, il est également proposé un récepteur appartenant à au moins un système de communication sans fil, comportant une antenne pour recevoir un signal incident et un dispositif de traitement tel que défini ci avant.

Le récepteur peut ainsi former une plate-forme de réception multi-normes capable par exemple de traiter des signaux compatibles avec la norme WiMAX ou WiFi.

D'autres avantages et caractéristiques de l'invention apparaîtront à l'examen de la description détaillée de modes de mise en oeuvre et de réalisation, nullement limitatifs, et des dessins annexés sur lesquels :

- la figure 1 illustre schématiquement un mode de réalisation d'un récepteur multi-normes incorporant un exemple de dispositif de conversion de fréquence d'échantillonnage selon l'invention ;
- les figures 2 et 3 illustrent schématiquement des exemples de mise en oeuvre d'un procédé de conversion de fréquence d'échantillonnage selon l'invention ;
- les figures 4 et 5 illustrent un exemple de mise en oeuvre de l'invention avec un exemple de filtre d'interpolation ;
- la figure 6 illustre schématiquement un exemple de détermination des contributions d'un échantillon d'entrée ;
- les figures 7 à 9 illustrent plus précisément un exemple de caractéristiques d'un filtre d'interpolation selon l'invention ;
- la figure 10 illustre plus en détail un exemple de réalisation d'un dispositif de conversion de fréquence d'échantillonnage selon l'invention ;
- les figures 11 à 13 illustrent un exemple de fonctionnement du dispositif de la figure 10, et
- les figures 14 et 15 illustrent des courbes d'évolution de puissance consommée.

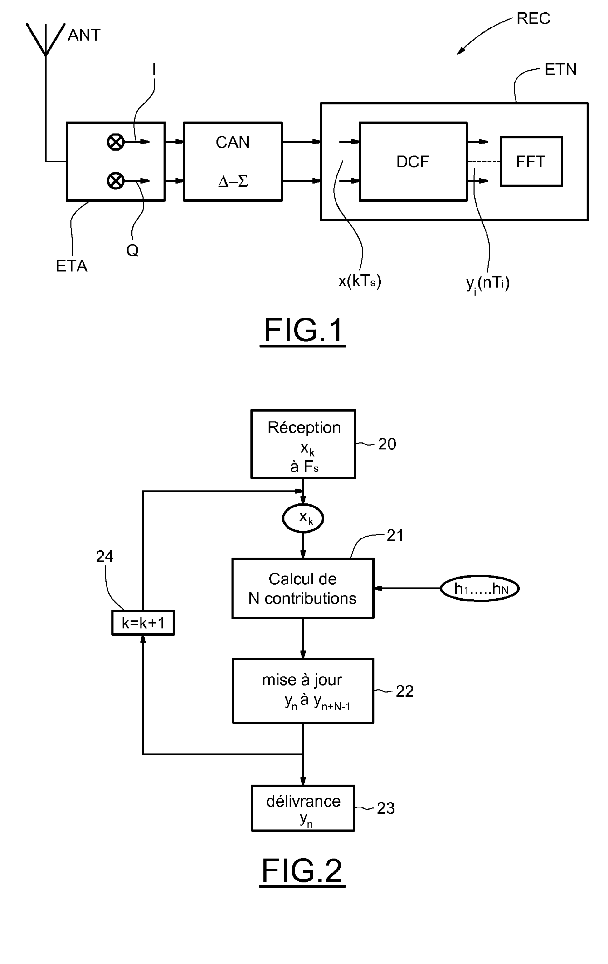

Sur la figure 1, la référence REC désigne un récepteur multi-normes capable de traiter des signaux compatibles avec différentes normes de transmission, comme par exemple les normes WiMAX et WiFi.

Plus précisément, cette plate-forme de réception REC comporte une antenne ANT capable de recevoir un signal incident compatible avec l'une des normes de transmission. Un étage de traitement analogique ETA est connecté à l'antenne ANT et comporte notamment des mélangeurs capables d'effectuer une transposition de fréquence pour ramener par exemple, le signal analogique en bande de base selon deux voies de traitement en quadrature, à savoir la voie « I » (en phase) et la voie « Q » (en quadrature de phase) selon une dénomination classique et connue de l'homme du métier.

A cet étage de traitement analogique ETA est couplé un étage de conversion analogique/numérique CAN, préférentiellement du type delta-sigma. La structure d'un tel étage de conversion analogique/numérique du type delta-sigma est classique et bien connue de l'homme du métier.

Un étage de traitement numérique ETN, est couplé à la sortie de l'étage de conversion analogique/numérique CAN et comporte notamment un dispositif de conversion de fréquence d'échantillonnage DCF suivi par d'autres modules de traitement, par exemple un module de transformée de Fourrier FFT, réalisé par exemple au sein d'un processeur, communément appelé par l'homme du métier « processeur de traitement en bande de base ».

Dans les systèmes de communication sans fil utilisant par exemple une modulation du type OFDM (acronyme anglosaxon pour « Orthogonal Frequency Division Multiplexing »), qui est une modulation de signaux numériques par répartition en fréquences orthogonales, la fréquence d'échantillonnage du convertisseur analogique numérique n'est pas nécessairement un multiple de la fréquence d'échantillonnage requise pour le bloc FFT et spécifiée par les normes.

A titre indicatif, pour les normes WiFi-WiMAX, la fréquence d'échantillonnage du signal attaquant le module FFT peut être choisie parmi les valeurs suivantes :

pour les normes WiFi : 10-20 MHz,
pour les normes WiMax : 4 ; 5,6 ; 8 ; 10 ; 11,2 ; 22,4 MHz.

Il apparaît donc nécessaire dans cette application que le dispositif de conversion de fréquence d'échantillonnage DCF puisse être capable d'effectuer une décimation de fréquence, c'est-à-dire une conversion descendante de fréquence d'échantillonnage, dans un rapport non entier, et pas nécessairement un rapport rationnel. Ce rapport de conversion peut donc être un nombre réel non entier supérieur à 1 bien que des nombres entiers supérieur à 1 soient également possibles.

En outre, comme on le verra plus en détail ci après, le dispositif DCF comporte des moyens de sélection capables de sélectionner le rapport de conversion $F_s/F_i$ dans un ensemble de valeurs prédéterminées, par exemple l'ensemble de valeurs mentionnées ci-dessus. La fréquence $F_s$ désigne la fréquence d'échantillonnage du signal en amont du dispositif DCF, et est aussi appelé par la suite « première fréquence d'échantillonnage », tandis que $F_i$ désigne la fréquence d'échantillonnage du signal numérique délivré par le dispositif DCF, encore appelé « deuxième fréquence d'échantillonnage ».

Dans la suite du texte, on considérera, à titre d'exemple, que le signal numérique $x(kT_s)$ reçu par le dispositif DCF, est un signal en bande de base, ayant une bande de fréquence limitée (variant de -B/2 à +B/2 où B désigne la largeur de bande du signal) largement suréchantillonnée avec une fréquence d'échantillonnage $F_s = 1/T_s$. Cette fréquence d'échantillonnage $F_s$ est très largement supérieure à B/2, par exemple de l'ordre de dix à quinze fois B/2. $y_i(nT_i)$ désigne le signal numérique échantillonné à la fréquence $F_i$ après conversion de la fréquence d'échantillonnage.

Comme on le verra plus en détail ci après, cette conversion de fréquence d'échantillonnage s'effectue à partir notamment d'un filtre d'interpolation. A cet égard, on note $h_I(t)$ la réponse impulsionnelle du filtre d'interpolation dans le domaine temporel.

Le spectre fréquentiel X(f) du signal d'entrée est périodique avec une période $F_s$, ce qui signifie qu'il y a des répliques du signal à des fréquences espacées de $F_s$. Par ailleurs, l'opération de filtrage est équivalente à une somme discrète.

Le signal numérique de sortie, ré-échantillonné à la fréquence $F_i$ peut s'exprimer par la formule (I) ci-dessous :

$$ y_i(nT_i) = y(t) . \sum_n \delta(t - nT_i) \qquad (I) $$

L'équivalent de cette formule (I) dans le domaine fréquentiel s'exprime par la formule (II) ci-dessous :

$$ Y_i(f) = \left[ X(f) x H_I(f) \right] * \sum_n \delta(f - nF_i) \qquad (II) $$

Cette équation montre l'effet bien connu du repliement. Chaque signal contenu dans une bande de fréquences $[rF_i-B/2 ; rF_i+B/2]$ sera ajouté, en raison de la convolution, au signal utile contenu dans la bande de fréquence [-B/2 ; +B/2].

Dans la suite du texte, à des fins de simplification, on désignera par $x_k$ les échantillons du signal d'entrée et on désignera par $y_n$ les échantillons de sortie.

Si l'on se réfère maintenant plus particulièrement à la figure 2, on voit qu'on reçoit (étape 20) les échantillons d'entrée à la première fréquence d'échantillonnage $F_s$.

On élabore les échantillons de sortie $y_n$ correspondants à la deuxième fréquence d'échantillonnage $F_i$ à partir des échantillons d'entrée et d'un filtre d'interpolation dont la réponse impulsionnelle dans le domaine temporel est égale à $h_I$.

Le rapport $F_s/F_i$ est strictement supérieur à 1 et est par exemple un nombre non entier, rationnel ou irrationnel.

L'élaboration des échantillons de sortie comporte, pour chaque échantillon d'entrée courant $x_k$, la mise à jour (étape 22) des valeurs courantes de N échantillons de sortie successifs avec N contributions respectivement calculées (étape 21) à partir de la valeur de l'échantillon d'entrée courant $x_k$ pondérée par les valeurs de N coefficients du filtre h1, ...hN, associées à cet échantillon d'entrée courant. Il convient de noter ici que le nombre N est fixé et identique pour tous les échantillons d'entrée $x_k$, quelle que soit la valeur du rapport $F_s/F_i$.

Par ailleurs, comme on le verra plus en détail ci après, on effectue la délivrance 23 d'un échantillon de sortie $y_n$ dont la valeur a été mise à jour avec une contribution provenant d'un échantillon d'entrée courant $x_k$ si cet échantillon de sortie ne doit pas recevoir de contribution provenant de l'échantillon d'entrée suivant $x_{k+1}$. Dans ce cas, la valeur effective de cet échantillon de sortie délivré est la valeur mise à jour avec la contribution provenant de l'échantillon d'entrée courant $x_k$.

Dans le cas contraire, c'est-à-dire si l'échantillon $y_n$ doit recevoir une contribution provenant de l'échantillon d'entrée suivant $x_{k+1}$, on répète les étapes 21 et 22 pour l'échantillon $x_{k+1}$ (étape 24).

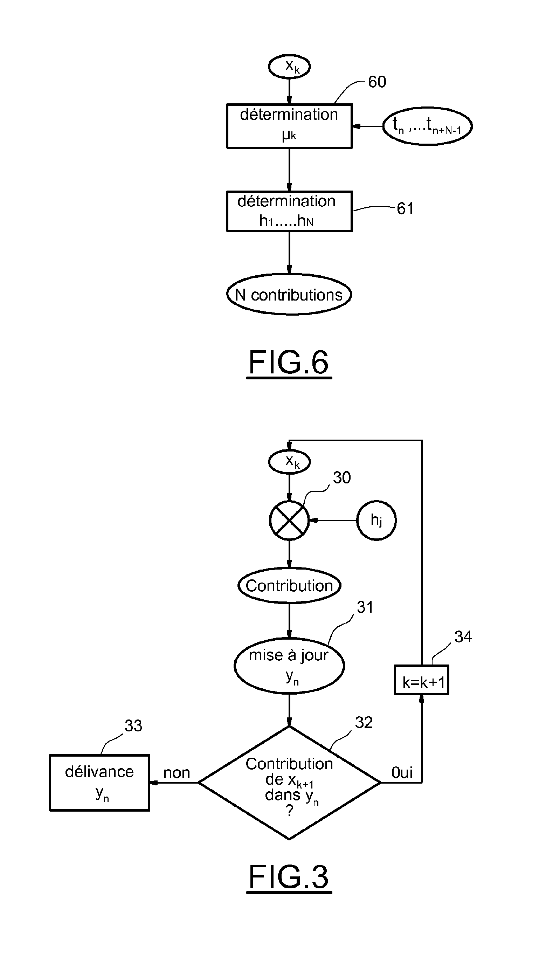

Ceci est illustré plus précisément sur la figure 3. La contribution pour la mise à jour 31 de l'échantillon $y_n$ est égale au produit 30 de la valeur de l'échantillon d'entrée courant $x_k$ par la valeur $h_j$ du coefficient correspondant du filtre.

Après la mise à jour de l'échantillon $y_n$ avec cette contribution, on détermine (étape 32) si l'échantillon d'entrée

suivant $x_{k+1}$ doit ou non apporter une contribution à la valeur de l'échantillon de sortie $y_n$.

Si la réponse est non, on délivre alors l'échantillon de sortie $y_n$ avec sa valeur effective égale à sa dernière valeur mise à jour. Si la réponse est oui, on calculera, pour l'échantillon d'entrée suivant $x_{k+1}$ (étape 34) la nouvelle contribution d'une façon analogue à celle qui vient d'être décrite pour l'échantillon d'entrée courant $x_k$.

D'une façon générale, la largeur de la réponse impulsionnelle du filtre d'interpolation fixe la valeur du nombre N. Ainsi, par exemple, si on choisit un filtre d'interpolation dont la largeur de la réponse impulsionnelle est égale au produit $cm.T_i$ (où cm désigne un coefficient multiplicateur, non nécessairement entier, et $T_i$ la deuxième période temporelle correspondant à la deuxième fréquence d'échantillonnage $F_i$), la valeur N est égale à la partie entière supérieure du coefficient multiplicateur cm (N=⌈cm⌉).

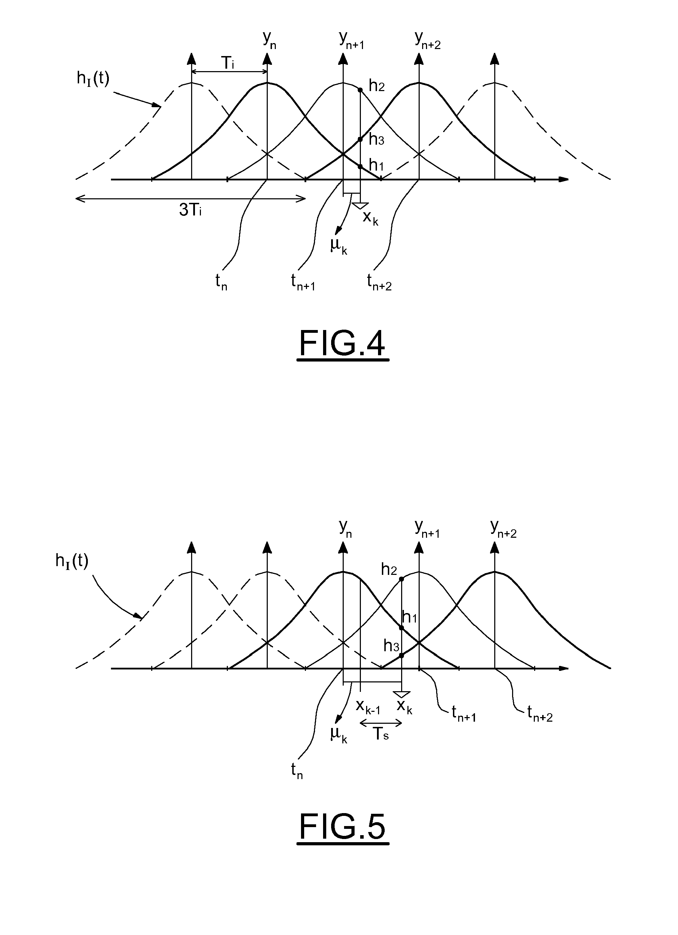

Dans l'exemple illustré sur les figures 4 et 5, le filtre d'interpolation a une largeur de bande égale à $2,5.T_i$. Le nombre N est par conséquent égal à 3, c'est-à-dire que chaque échantillon d'entrée va contribuer à la mise à jour de trois échantillons de sortie.

On suppose également dans cet exemple que la réponse impulsionnelle $h_l(t)$ est une fonction paire (c'est-à-dire $h_l(t)$ est égal à $h_l(-t)$ et $h_l(t)$ est égal à zéro si t n'appartient pas à l'intervalle $[-3T_i/2;3T_i/2]$).

Le calcul des N contributions (N=3 ici) de chaque échantillon d'entrée courant, comporte la détermination de la position temporelle de cet échantillon d'entrée $x_k$ par rapport aux N instants temporels, $t_n$, $t_{n+1}$, $t_{n+2}$ (figures 4 et 5) que l'on dénommera « instants temporels d'interpolations », et qui sont mutuellement espacés de la deuxième période temporelle $T_i$ et respectivement associés aux N=3 échantillons de sortie mis à jour $y_n$, $y_{n+1}$, $y_{n+2}$.

Et, cette position temporelle est prise en compte dans la détermination des valeurs des N coefficients du filtre (N=3 ici).

Ceci est illustré plus précisément sur la figure 6, dans le cas général N.

Plus précisément, selon cette mise en oeuvre, et si l'on désigne par « premiers instants temporels » les instants temporels auxquels arrivent les échantillons d'entrée $x_k$, la détermination de la position temporelle d'un échantillon d'entrée courant $x_k$ par rapport aux N instants temporels d'interpolation $t_n$, ..., $t_{n+N-1}$, comprend la détermination d'un intervalle temporel $\mu_k$ entre le premier instant temporel associé à l'échantillon d'entrée courant $x_k$ et l'un des N instants temporels d'interpolation, par exemple l'instant temporel d'interpolation précédent.

Dans le cas de la figure 4, l'instant temporel d'interpolation précédent est l'instant $t_{n+1}$, tandis que c'est l'instant $t_n$ dans la configuration illustrée sur la figure 5.

Comme illustré sur la figure 6, à partir de la détermination 60 de $\mu_k$, on va déterminer (étape 61) les valeurs des N coefficients du filtre h1, ...hN avec lesquelles seront calculées les N contributions de l'échantillon d'entrée courant $x_k$.

Dans l'exemple illustré sur les figures 4 et 5, le calcul des coefficients h1, h2 et h3 dépend de la position de $\mu_k$ par rapport à la valeur 0,5.

Plus précisément, si la valeur de $\mu_k$ est inférieure à 0,5, on se trouve dans la configuration de la figure 4.

Dans ce cas, on voit que les trois coefficients h1, h2 et h3 sont respectivement déterminés par les formules (III) (IV) et (V) suivantes :

$$h1 = h_I\left(1+\mu_k\right) \qquad (\mathrm{III})$$

$$h2 = h_I\left(\mu_k\right) \qquad (\mathrm{IV})$$

$$h3 = h_I\left(1-\mu_k\right) \qquad (\mathrm{V})$$

On notera à cet égard que $(1+\mu_k)$ et $(1-\mu_k)$ représentent deux autres intervalle temporels entre respectivement l'instant d'arrivée de l'échantillon courant $x_k$, et les autres instants temporels d'interpolation $t_n$ et $t_{n+2}$.

Dans le cas où $\mu_k$ est supérieur à 0,5, on se trouve dans la configuration illustrée sur la figure 5. Dans ce cas, les coefficients h1, h2 et h3 sont respectivement donnés par les formules (VI), (VII) et (VIII) ci-dessous :

$$h1 = h_I(\mu_k) \qquad\qquad (VI)$$

$$h2 = h_I(1-\mu_k) \qquad\qquad (VII)$$

$$h3 = h_I(2-\mu_k) \qquad\qquad (VIII)$$

Un exemple d'algorithme d'élaboration de la valeur des échantillons de sortie peut être le suivant :

- pour un échantillon d'entrée courant $x_k$, étape a) : calcul de la valeur de $\mu_k$ par la formule :

$$\mu_k = [\mu_{k-1} + R](\mathrm{mod}\,1) \qquad\qquad (IX)$$

(dans cette formule, R désigne le rapport de décimation fractionnaire $T_s/T_i$ qui est inférieur à 1 et mod désigne la fonction modulo).

Une fois la valeur de $\mu_k$ déterminée, on peut calculer les coefficients du filtre h1, h2, h3 associés à cet échantillon d'entrée courant $x_k$, de la façon suivante (étape b)) :
si $\mu_k \le 0.5$

$$h1 = h_I(1+\mu_k) \quad h2 = h_I(\mu_k) \quad h3 = h_I(1-\mu_k)$$

sinon

$$h1 = h_I(\mu_k) \quad h2 = h_I(1-\mu_k) \quad h3 = h_I(2-\mu_k)$$

On peut alors mettre à jour les valeurs des trois échantillons de sortie $y_n$, $y_{n+1}$ et $y_{n+2}$ de la façon suivante (étape c)) :

$$y_n = y_n + h1 \cdot x_k$$

$$y_{n+1} = y_{n+1} + h2 \cdot x_k$$

$$y_{n+2} = y_{n+2} + h3 \cdot x_k$$

On vérifie ensuite (étape d) si l'échantillon de sortie $y_n$ est prêt à être délivré avec sa valeur effective, c'est-à-dire si oui ou non il devra recevoir une contribution provenant de l'échantillon d'entrée suivant $x_{k+1}$.
A cet égard, on vérifie si la condition suivante CD1 est satisfaite, c'est-à-dire si

$$(\mu_k \le 0.5 \text{ et } \mu_k + R \ge 0.5) \text{ ou } \mu_k + R > 1.5 \qquad\qquad (CD1)$$

Si cette condition CD1 est satisfaite, on est alors sûr que $y_n$ ne recevra pas de contribution de la part de $x_{k+1}$.

Dans ce cas, $y_n$ est prêt à être délivré.

Si tel est le cas, on délivre effectivement l'échantillon de sortie $y_n$ en sortie et, comme on le verra plus en détail, on effectue un décalage des registres auxquels sont affectés les échantillons de sortie et dans lesquels on accumule pour l'échantillon de sortie considéré les différentes contributions issues des différents échantillons d'entrée.

Dans le cas contraire (condition CD1 non satisfaite), c'est-à-dire si l'échantillon de sortie n'est pas prêt à être délivré parce qu'il va recevoir une contribution de l'échantillon d'entrée suivant $x_{k+1}$, on recommence les étapes a) à d) qui viennent d'être décrites, pour l'échantillon suivant $x_{k+1}$.

En particulier, lorsque le convertisseur analogique/numérique CAN est un convertisseur du type delta-sigma, il est particulièrement intéressant de choisir un filtre d'interpolation dont la courbe de réponse amplitude/fréquence présente des « 0 » aux fréquences multiples de la deuxième fréquence d'échantillonnage $F_i$.

Par ailleurs, pour un exemple particulier d'allure de mise en forme du convertisseur CAN de type delta-sigma, on ne recherche aucune atténuation du signal dans la bande utile du signal et au moins 60 dB d'atténuation dans les bandes $[rF_i \pm B/2]$.

Une solution acceptable consiste alors à utiliser une fonction sinus cardinal (sinc) pour la courbe de réponse amplitude/fréquence du filtre. Plusieurs solutions sont possibles selon le niveau d'atténuation souhaité. On peut à cet égard utiliser soit une simple fonction sinc, soit le produit d'une fonction sinc par une fonction cosinus, soit une fonction sinc2 (sinus cardinal élevé au carré) ou alors le produit d'une fonction sinc2 par une fonction cosinus, ou bien encore une fonction sinc3 (sinus cardinal élevé au cube) ou bien le produit de cette fonction sinc3 par une fonction cosinus ou encore d'autres fonctions combinant ou non la fonction sinus cardinal.

A titre indicatif, pour obtenir au moins 60 dB d'atténuation dans les bandes désirées, on peut choisir une forme du type sinc2.cos.

On pourra ainsi choisir la courbe de réponse amplitude/fréquence $H_I(f)$ définie par la formule ci-dessous.

$$H_I(f) = \sin_c\left(\frac{f}{F_i}\right)^2 . \cos\left(2\pi \frac{f}{4F_i}\right) \qquad (X)$$

Ce qui correspond, après transformée de Fourrier inverse, à une réponse impulsionnelle $h_i(t)$ égale à la formule ci-dessous.

$$h_i(t) = \Pi_{Ti}(t) * \Pi_{Ti}(t) * \frac{1}{2}\left[\delta\left(t - \frac{T_i}{4}\right) + \delta\left(t + \frac{T_i}{4}\right)\right] \qquad (XI)$$

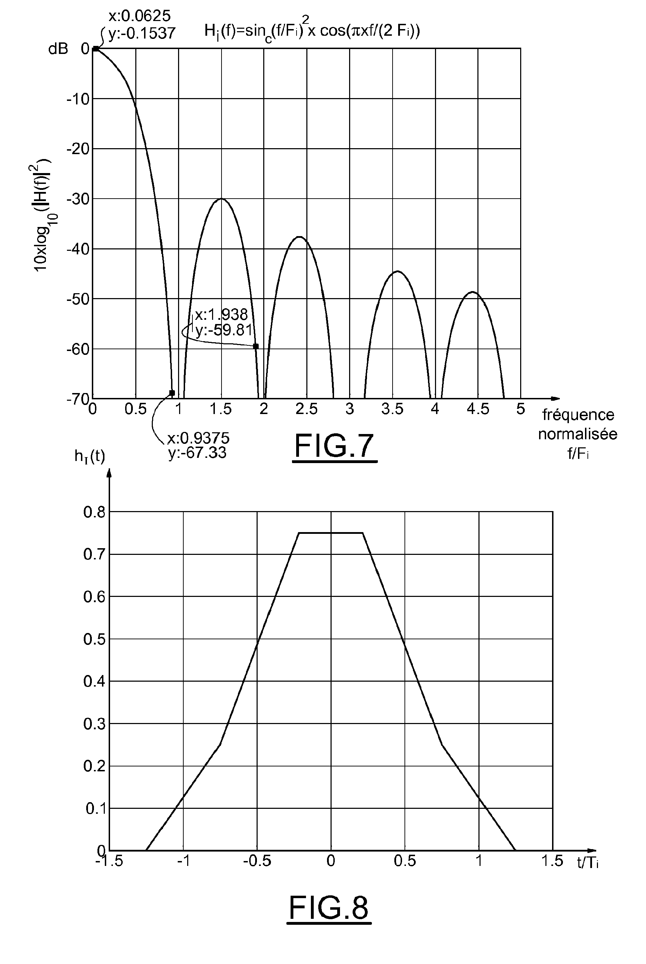

Une telle courbe de réponse amplitude/fréquence est illustrée sur la figure 7, tandis que la figure 8 représente la réponse impulsionnelle correspondante $h_I(t)$.

Comme la réponse impulsionnelle du filtre d'interpolation est basée sur $T_i$ et que $T_i$ est aussi la base de la référence temporelle pour le calcul d'interpolation (voir figures 4 et 5), il devient alors possible de déterminer chacun des N coefficients du filtre (N=3 dans l'exemple) à partir d'une fonction de l'intervalle temporel $\mu k$.

Ceci simplifie le calcul des coefficients du filtre.

Et plus encore, pour un filtre du type de ceux utilisant le produit d'une fonction sinus cardinal par une fonction cosinusoïdale, comme par exemple celui illustré sur les figures 7 et 8, cette fonction peut comporter au moins une zone linéaire.

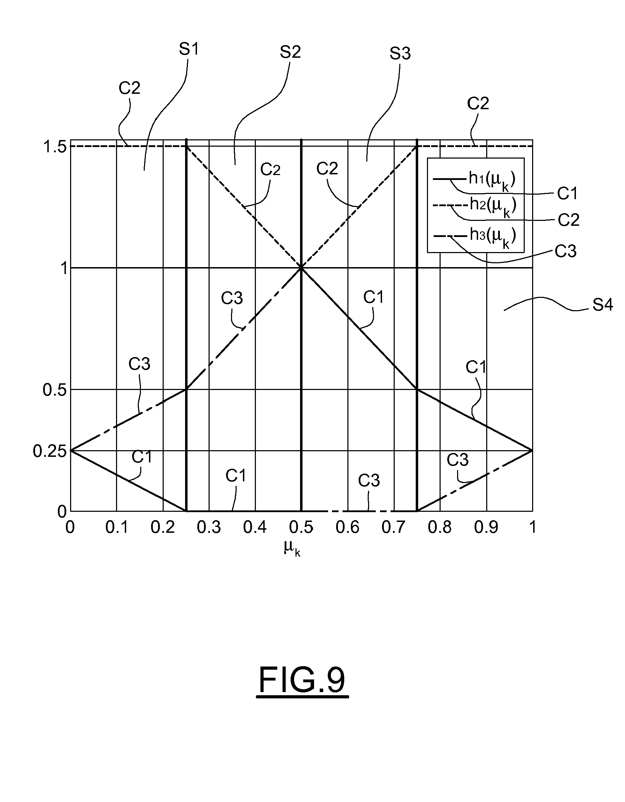

Ceci est illustré sur la figure 9. Sur cette figure, la courbe C1 représente l'évolution du coefficient h1 en fonction de $\mu_k$.

La courbe C2 représente l'évolution du coefficient h2 en fonction de $\mu_k$ et la courbe C3 représente l'évolution du coefficient h3 en fonction de $\mu_k$. On voit que ces courbes sont formées de zones linéaires, en l'espèce des segments de droites.

Il convient également de noter qu'à des fins de clarification, les valeurs des coefficients h1, h2 et h3 ont été volontairement multipliées par 2 sur la figure 9.

Sur la figure 9, on voit que si l'on subdivise l'axe des abscisses en quatre secteurs S1, S2, S3 et S4, en fonction de la plage de valeurs de $\mu_k$, on peut définir, comme indiqué dans le tableau ci-dessous, un intervalle temporel auxiliaire $\mu'_k$ dont la valeur est égale à celle de l'intervalle temporel $\mu_k$ mais rapportée dans la plage [0 ; 0,25[. En d'autres termes, $\mu'_k$ appartient toujours à la plage [0 ; 0,25[.

| Plage de $\mu_k$ | $\mu_k \in [0;0.25[$ | $\mu_k \in [0.25;0.5[$ | $\mu_k \in [0.5;0.75[$ | $\mu_k \in [0.75;1[$ |
|---|---|---|---|---|
| | $\mu'_k = \mu_k$ et $R_k = 0$ | $\mu'_k = \mu_k - 0.25$ et $R_k = 1$ | $\mu'_k = \mu_k - 0.5$ et $R_k = 2$ | $\mu'_k = \mu_k - 0.75$ et $R_k = 3$ |
| $h_1$ | $h_1(\mu'_k) = 0.25 - \mu'_k$ | $h_1(\mu'_k) = 0$ | $h_1(\mu'_k) = 1 - 2\mu'_k$ | $h_1(\mu'_k) = 0.5 - \mu'_k$ |
| $h_2$ | $h_2(\mu'_k) = 1.5$ | $h_2(\mu'_k) = 1.5 - 2\mu'_k$ | $h_2(\mu'_k) = 0.5 + 2\mu'_k$ | $h_2(\mu'_k) = 1.5$ |
| $h_3$ | $h_3(\mu'_k) = 0.25 + \mu'_k$ | $h_3(\mu'_k) = 0.5 + 2\mu'_k$ | $h_3(\mu'_k) = 0$ | $h_3(\mu'_k) = \mu'_k$ |

Dans le tableau ci-dessus, la valeur logique $R_k$ désigne, en fonction de sa valeur, les quatre secteurs correspondant aux plages de valeurs de $\mu_k$.

On voit donc dans ce tableau que des expressions linéaires peuvent être obtenues entre les coefficients h1, h2, h3 et $\mu_k$.

Il est donc possible de calculer en ligne les coefficients du filtre d'interpolation à partir de $\mu_k$ sans qu'il soit nécessaire de les calculer au préalable pour toute valeur de $\mu_k$ et de les stocker dans une mémoire.

Il en résulte par conséquent un gain de place considérable.

Par ailleurs, avec le changement de paramètres ($\mu_k$ en $\mu'_k$), une seule multiplication par $\mu'_k$ est nécessaire pour calculer la contribution d'un échantillon d'entrée courant $x_k$.

En effet, à titre d'exemple, dans le secteur correspondant à $R_k=0$, la contribution h1.$x_k$ est égale à $(0,25-\mu'_k) x_k$, ce qui s'écrit également $0,25 \cdot x_k - \mu'_k x_k$.

On voit donc qu'une seule multiplication par $\mu'_k$ est nécessaire. En effet, la multiplication de $x_k$ par 0,25 est en fait une division de $x_k$ par 4, ce qui peut se réaliser très aisément par un décalage de bits.

Il en résulte donc une importante réduction de la complexité de mise en oeuvre et de réalisation du dispositif correspondant. Ce mode de réalisation permet donc ici d'éviter de faire trois multiplications et de prévoir un accès rapide à une mémoire. En outre, la seule multiplication effectuée l'est sur un faible nombre de bits.

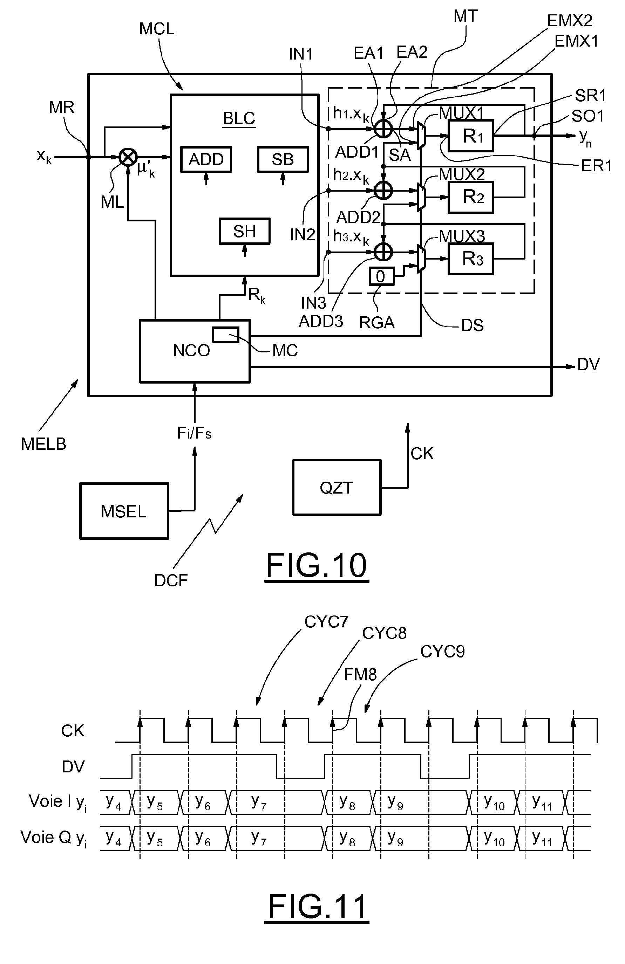

On va maintenant décrire en se référant plus particulièrement aux figures 10 à 13, un exemple de réalisation d'un dispositif de conversion de fréquence d'échantillonnage DCF selon l'invention.

Comme illustré sur la figure 10, le dispositif DCF comporte une entrée de réception MR apte à recevoir les échantillons $x_k$ du signal numérique, des moyens d'élaboration MELB aptes à élaborer les échantillons de sortie $y_n$, et des moyens de sortie SO1 aptes à délivrer ces échantillons de sortie $y_n$.

Le dispositif DCF comporte en outre des moyens de sélection MSEL aptes à sélectionner la valeur du rapport $F_s/F_i$ parmi un jeu de valeurs prédéterminées correspondant à des valeurs de fréquence d'échantillonnage compatibles avec plusieurs normes différentes, par exemple les normes WiMAX ou WiFi. Il convient de noter ici que les moyens de sélection MSEL sélectionnent en fait l'inverse de ce rapport.

Les moyens d'élaboration MELB comportent des moyens de calcul MCL aptes à calculer les N contributions de chaque échantillon d'entrée courant $x_k$, et des moyens de traitement aptes à effectuer la mise à jour des valeurs des échantillons de sortie.

Dans l'exemple de réalisation décrit sur la figure 10, et qui correspond à une réalisation particulièrement simple mettant en oeuvre le calcul en ligne des coefficients du filtre d'interpolation à partir du paramètre $\mu'_k$ conformément à la table ci-dessus, les moyens de calcul MCL comportent des premiers moyens aptes à déterminer la position temporelle d'un échantillon d'entrée courant par rapport aux N instants temporels d'interpolation respectivement associés aux N échantillons de sortie destinés à être mis à jour, et des deuxièmes moyens aptes à déterminer les valeurs des N coefficients du filtre à partir de cette position temporelle. Dans l'exemple décrit ici, la position temporelle est déterminée par l'intermédiaire du paramètre $\mu'_k$. Et, les premiers moyens comportent un oscillateur commandé numériquement NCO capable, à partir des périodes $T_s$ et $T_i$, et d'un signal d'horloge CK de période $T_s$, délivré par un quartz QZT par exemple, de déterminer le paramètre $\mu'_k$ pour un échantillon d'entrée courant $x_k$.

Les moyens de calcul MCL comportent en outre un multiplieur ML recevant d'une part l'échantillon courant $x_k$ et d'autre part, le paramètre $\mu'_k$. La sortie du multiplieur ainsi que l'échantillon $x_k$ sont connectés à deux entrées d'un bloc BLC comportant des additionneurs ADD, des soustracteurs SB, et des moyens de décalage de bits SH, tous ces moyens étant individuellement sélectionnables en fonction de la valeur de l'intervalle temporel $\mu_k$, c'est-à-dire en fonction du paramètre logique $R_k$ délivré par l'oscillateur NCO.

En fait, dans cet exemple, le calcul des valeurs des coefficients du filtre et le calcul des contributions sont faits globalement au sein du bloc BLC.

Les moyens de traitement MT comportent trois entrées (N=3) IN1, IN2, IN3 aptes à recevoir respectivement les trois contributions d'un échantillon d'entrée courant.

Les moyens de traitement peuvent être par ailleurs trois additionneurs ADD1, ADD2, ADD3, possédant chacun une première entrée EA1 couplée à l'entrée correspondante des moyens de traitement (IN1, IN2 ou IN3) et une deuxième entrée EA2.

Les moyens de traitement comportent également trois multiplexeurs MUX1, MUX2, MUX3 aptes à être commandés par des moyens de commande MC fonctionnellement incorporés au sein de l'oscillateur NCO, et possédant chacun une première entrée EMX1 connectée à la sortie SA de l'additionneur correspondant, et une deuxième entrée EMX2.

Les moyens de traitement comportent également une chaîne de trois registres R1, R2, R3 possédant chacun une entrée ER1 couplée à la sortie du multiplexeur correspondant et une sortie SR1 couplée à la deuxième entrée EA2 de l'additionneur correspondant.

Par ailleurs, la sortie du dernier registre de la chaîne, en l'espèce le registre R1, est couplée à la sortie SO1, tandis que la sortie de chacun des autres registres R2, R3 est couplée à la deuxième entrée du multiplexeur associé au registre suivant dans ladite chaîne de registres. Plus précisément, la sortie du registre R3 est couplée à la deuxième entrée du multiplexeur MUX2 tandis que la sortie du registre R2 est couplée à la deuxième entrée du registre MUX1.

Les moyens de traitement comportent également un registre auxiliaire RGA contenant une donnée de valeur nulle et dont la sortie est couplée à la deuxième entrée du multiplexeur MUX 3 associé au premier registre R3 de la chaîne.

On se réfère maintenant plus particulièrement aux figures 11, 12 et 13 pour illustrer un exemple de fonctionnement du dispositif de la figure 10.

Le dispositif DCF est cadencé au rythme du signal d'horloge CK, un échantillon d'entrée $x_k$ arrivant par exemple à chaque front montant du signal d'horloge CK.

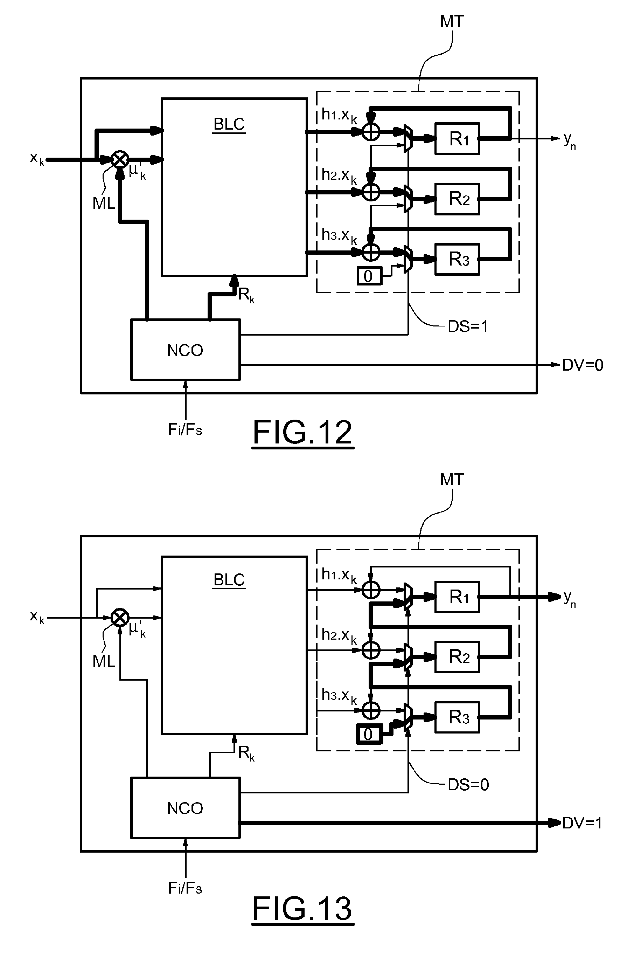

Pendant une période du signal d'horloge CK, les trois contributions de l'échantillon d'entrée courant $x_k$ sont calculées et transmises aux moyens de traitement. Le signal de commande DS qui commande les multiplexeurs des moyens de traitement prend la valeur 1, ce qui relie la première entrée des multiplexeurs à leur sortie, et donc reboucle la sortie de chacun des registres sur la deuxième entrée de l'additionneur correspondant. Ceci permet d'accumuler dans chacun des registres la contribution correspondante et de mettre à jour la valeur correspondante de l'échantillon de sortie (figure 12).

Une fois cette mise à jour effectuée, l'oscillateur NCO détermine en appliquant la condition CD1 mentionnée ci avant, si l'échantillon $y_n$ doit ou non être délivré en sortie. Si tel n'est pas le cas, un signal logique DV prend la valeur « 0 », indiquant que la sortie du registre R1 n'est pas une donnée valide.

Dans le cas contraire, le signal DV monte à « 1 », indiquant que la sortie du registre R1 est valide.

Dans l'exemple qui est décrit ici, on met à jour des échantillons de sortie de rang n à n+2 et, à cet égard, on affecte respectivement à ces trois échantillons de sortie les trois registres R1, R2 et R3 dans chacun desquels on accumule pour l'échantillon de sortie considéré, les différentes contributions issues des différents échantillons d'entrée.

Lorsque l'échantillon $y_n$ doit être délivré, on délivre la valeur contenue dans le registre R1 et on affecte les registres R1 et R2 aux échantillons $y_{n+1}$ et $y_{n+2}$, tandis qu'on affecte au registre R3 l'échantillon de sortie $y_{n+3}$. Et, on initialise le registre R3 à une valeur d'initialisation choisie, en l'espèce la valeur « 0 ». Ce décalage de registres s'effectue au moyen du signal de commande DS qui prend la valeur « 0 » par exemple, et qui permet de relier les deuxièmes entrées des multiplexeurs à leurs sorties correspondantes (figure 13).

Bien entendu, tant que le signal DV est à « 0 », on reste dans la configuration de la figure 12 en accumulant les différentes contributions issues des différents échantillons d'entrée.

Cela étant, tous les échantillons de sortie ne reçoivent pas forcément un nombre identique de contributions pour leur mise à jour.

Ceci est illustré sur la figure 11.

Sur cette figure, et à des fins de clarté, on a légèrement décalé les fronts du signal DV par rapport au front montant du signal d'horloge CK.

Dans l'exemple décrit, on voit que l'échantillon $y_4$ (sur la voie I et sur la voie Q) est prêt à être délivré sur le premier front montant du signal d'horloge CK, ce qui se traduit par la montée à « 1 » du signal DV.

Pendant le cycle suivant du signal d'horloge CK, l'échantillon $y_5$ est mis à jour et est également prêt à être délivré. En conséquence, le signal DV reste à « 1 » et l'échantillon $y_5$ sera délivré sur le front montant suivant du signal d'horloge CK.

Au cours du cycle suivant, l'échantillon $y_6$ est encore mis à jour et est également prêt à être délivré sur le front montant suivant du signal d'horloge CK. Le signal DV est toujours à « 1 ».

Au cours du cycle suivant CYC7, l'échantillon de sortie suivant $y_7$ est toujours en cours d'élaboration. Cela étant, à la fin de ce cycle CYC7, l'échantillon $y_7$ n'est pas prêt à être délivré car son élaboration nécessite de recevoir la contribution d'un échantillon d'entrée suivant. Le signal DV retombe donc à « 0 » et reste à cette valeur pendant le cycle suivant CYC8, au cours duquel se poursuit l'élaboration de l'échantillon de sortie $y_7$ en mettant à jour sa valeur avec deux autres contributions provenant respectivement des deux échantillons d'entrée suivants. C'est seulement à la fin du cycle CYC8 que l'échantillon $y_7$ est prêt à être délivré, ce qui va se produire sur le front montant FM8 du signal d'horloge CK. Le signal DV reprend alors la valeur « 1 ».

Au cours du cycle suivant CYC9, va être délivré l'échantillon $y_8$. L'échantillon $y_9$ va également être mis à jour au cours du cycle CYC9 Mais cet échantillon nécessitera encore deux cycles d'horloge du signal CK pour être mis à jour avant d'être délivré. Puis l'échantillon $y_{10}$ et l'échantillon $y_{11}$ nécessiteront respectivement encore un et deux cycles d'horloge du signal CK pour être mis à jour avant d'être délivrés.

On voit donc que les échantillons de sortie $y_n$ sont délivrés au rythme des fronts montants du signal d'horloge CK, mais sur certains seulement de ces fronts montants en fonction du nombre de contributions nécessaires pour chacun des échantillons de sortie $y_n$.

Le nombre de contributions est différent pour les échantillons de sortie. Chaque nombre de contribution dépend de N, du rapport de conversion mais aussi de $\mu_k$ (voir condition CD1 ci-dessus). En général le nombre de contributions est supérieur ou égal à N, et en pratique bien supérieur à N.

La fréquence de délivrance des échantillons de sortie est donc différente de la fréquence d'échantillonnage $F_i$. Cela étant, du point de vue traitement du signal, les échantillons de sortie $y_n$ sont effectivement représentatifs d'un échantillonnage du signal numérique à une fréquence $F_i$.

Des simulations montrent que la puissance consommée d'un dispositif de conversion de fréquence conforme à des aspects de l'invention varie sensiblement linéairement avec la première fréquence d'échantillonnage $F_s$. Par contre, pour une fréquence $F_s$ donnée, cette puissance consommée est sensiblement constante quelle que soit la valeur du rapport de conversion $F_s/F_i$, alors que dans les solutions de l'art antérieur prévoyant un stockage de coefficients de filtre pour chaque rapport de conversion envisagé, la puissance consommée augmente lorsque la valeur du rapport de conversion augmente.

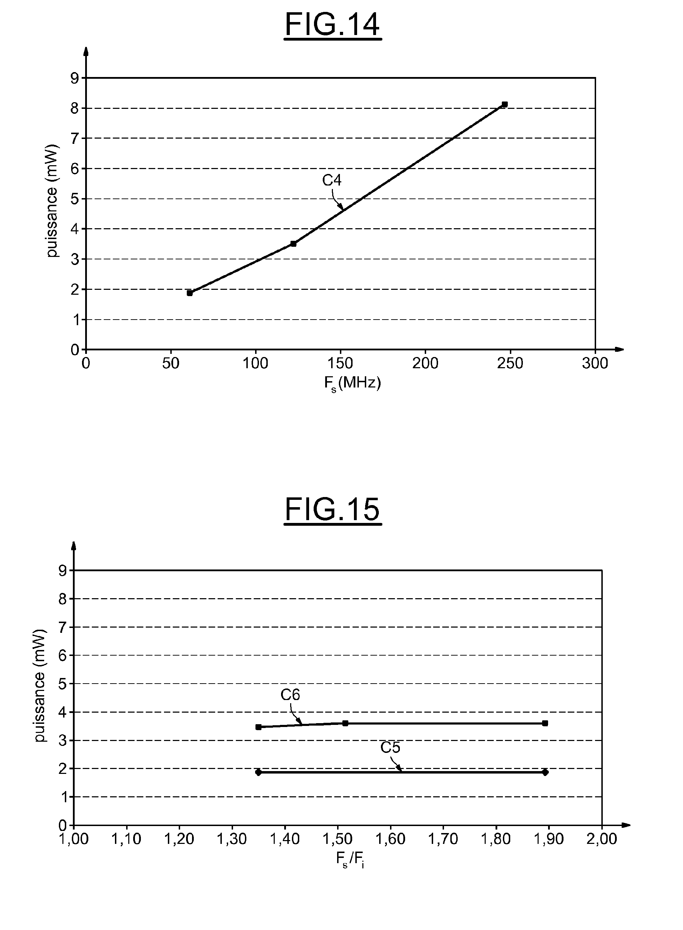

Ces résultats de simulation sont illustrés plus particulièrement sur les figures 14 et 15 qui concernent un dispositif du type de celui de la figure 10, réalisé en technologie 65 nm.

Sur la figure 14, la courbe C4 illustre la progression sensiblement linéaire de la puissance en fonction de $F_s$.

Sur la figure 15, la courbe C5 illustre le caractère sensiblement constant de la puissance en fonction du rapport de conversion, pour une fréquence $F_s$ égale à 60 MHz, tandis que la courbe C6 est tracée pour une fréquence $F_s$ égale à 120 MHz. Pour une fréquence $F_s$ égale à 240 MHz on obtiendrait une puissance sensiblement constante de l'ordre de 8 mW.

**Revendications**

1. Procédé de conversion de fréquence d'échantillonnage d'un signal numérique échantillonné à une première fréquence d'échantillonnage, **caractérisé par le fait qu'**il comprend une réception (20) d'échantillons d'entrée ($x_k$) du signal numérique, une élaboration (21, 22) d'échantillons de sortie correspondant ($y_n$) à une deuxième fréquence d'échantillonnage ($F_i$) à partir des échantillons d'entrée et d'un filtre d'interpolation, la première fréquence d'échantillonnage ($F_s$) étant plus grande que la deuxième fréquence d'échantillonnage ($F_i$), et une délivrance (23) desdits échantillons de sortie, ladite élaboration comportant pour chaque échantillon d'entrée courant la mise à jour (22) des valeurs courantes de N échantillons de sortie successifs avec N contributions respectivement calculées (21) à partir de la valeur de cet échantillon d'entrée courant pondérée par les valeurs de N coefficients du filtre (h1, ...hN) associés à cet échantillon d'entrée courant, ce nombre N étant fixé et identique pour tous les échantillons d'entrée quelle que soit la valeur du rapport de conversion ($F_s/F_i$) entre les deux fréquences.

2. Procédé selon la revendication 1, dans lequel on délivre (23) un échantillon de sortie dont la valeur a été mise à jour avec une contribution provenant d'un échantillon d'entrée courant si cet échantillon de sortie ne doit pas recevoir de contribution provenant de l'échantillon d'entrée suivant, la valeur effective de cet échantillon de sortie délivré étant ladite valeur mise à jour avec la contribution provenant de l'échantillon d'entrée courant.

3. Procédé selon la revendication 2, dans lequel lors de la mise à jour (22) des valeurs des échantillons de sortie de rangs n à n+N-1, on affecte respectivement à ces N échantillons de sortie N moyens de stockage (R1-R3) de rangs $r_1$ à $r_N$ dans chacun desquels on accumule, pour l'échantillon de sortie considéré, les différentes contributions issues des différents échantillons d'entrée, et la délivrance de l'échantillon de sortie de rang n avec sa valeur effective comporte

la délivrance de la valeur contenue dans le moyen de stockage de rang $r_1$,

l'affectation des registres de rangs $r_1$ à $r_{N-1}$ aux échantillons de sortie de rangs n+1 à n+N-1,

l'affectation du registre de rang $r_N$ à l'échantillon de sortie de rang n+N, et

l'initialisation du registre de rang $r_N$ à une valeur d'initialisation choisie.

4. Procédé selon l'une des revendications précédentes, dans lequel on reçoit les échantillons d'entrée et on élabore les échantillons de sortie au rythme des fronts d'un signal d'horloge (CK) ayant une fréquence égale à la première fréquence d'échantillonnage ($F_s$) et on délivre les échantillons de sortie sur certains seulement des fronts du signal d'horloge (CK).

**5.** Procédé selon l'une des revendications précédentes, dans lequel on sélectionne la valeur dudit rapport de conversion ($F_s/F_i$) parmi un jeu de valeurs comportant des valeurs non entières.

**6.** Procédé selon l'une des revendications précédentes, dans lequel on sélectionne la valeur dudit rapport de conversion ($F_s/F_i$) parmi un jeu de valeurs correspondant à des valeurs de deuxièmes fréquences d'échantillonnage compatibles avec plusieurs normes différentes, par exemple les normes WiMax ou WiFi.

**7.** Procédé selon l'une des revendications précédentes, dans lequel la largeur de la réponse impulsionnelle du filtre d'interpolation fixe la valeur du nombre N.

**8.** Procédé selon l'une des revendications précédentes, dans lequel on choisit un filtre d'interpolation dont la largeur de la réponse impulsionnelle ($h_l$) est égale au produit d'un coefficient multiplicateur par la deuxième période temporelle correspondant à la deuxième fréquence d'échantillonnage, et on fixe la valeur de N à une valeur égale à la partie entière supérieure du coefficient multiplicateur.

**9.** Procédé selon l'une des revendications précédentes, dans lequel on choisit un filtre d'interpolation dont la courbe de réponse amplitude/fréquence présente des zéros aux fréquences multiples de ladite deuxième fréquence d'échantillonnage ($F_i$).

**10.** Procédé selon la revendication 9, dans lequel la courbe de réponse amplitude/fréquence du filtre présente une forme du type produit de la fonction sinus cardinal élevée au carré par la fonction cosinus.

**11.** Procédé selon l'une des revendications précédentes, dans lequel le calcul des N contributions de chaque échantillon d'entrée courant comporte la détermination de la position temporelle ($\mu_k$) de cet échantillon d'entrée par rapport aux N instants temporels, dits instants temporels d'interpolation, mutuellement espacés d'une deuxième période temporelle correspondant à la deuxième fréquence d'échantillonnage et respectivement associés aux N échantillons de sortie mis à jour, et la prise en compte de ladite position temporelle dans la détermination des valeurs des N coefficients du filtre.

**12.** Procédé selon la revendication 11, dans lequel les échantillons d'entrée arrivent à des premiers instants temporels et la détermination de la position temporelle d'un échantillon d'entrée courant par rapport auxdits N instants temporels d'interpolation comprend la détermination d'un intervalle temporel ($\mu_k$) entre le premier instant temporel associé à cet échantillon d'entrée courant et l'un des N instants temporels d'interpolation, et la détermination des autres intervalles temporels entre ledit premier instants et les N-1 autres instants temporels d'interpolation à partir dudit intervalle temporel, et les valeurs des N coefficients du filtre correspondent respectivement aux valeurs de la réponse impulsionnelle du filtre à ces N intervalles temporels.

**13.** Procédé selon la revendication 12 prise en combinaison avec la revendication 9 ou 10, dans lequel la détermination de chacun des N coefficients du filtre est obtenue à partir d'une fonction dudit intervalle temporel ($\mu_k$).

**14.** Procédé selon la revendication 13, dans lequel ladite fonction comporte au moins une zone linéaire.

**15.** Procédé selon la revendication 14, dans lequel la valeur dudit intervalle temporel varie entre 0 et 1 et on définit un intervalle temporel auxiliaire ($\mu'_k$) à partir de cet intervalle temporel ($\mu_k$) dont la valeur est égale à celle dudit intervalle temporel rapportée dans la plage [0 ;0,25[, et le calcul d'une contribution d'un échantillon d'entrée courant comporte une seule multiplication de la valeur de cet échantillon d'entrée avec la valeur dudit intervalle temporel auxiliaire.

**16.** Procédé de traitement d'un signal analogique, comportant une conversion analogique/numérique du signal analogique et un procédé de conversion de fréquence d'échantillonnage selon l'une des revendications précédentes, d'un signal numérique issu de ladite conversion analogique/numérique.

**17.** Procédé selon la revendication 16, dans lequel ladite conversion analogique/numérique est du type delta-sigma.

**18.** Procédé selon la revendication 16 ou 17, dans lequel le signal analogique est un signal choisi parmi plusieurs signaux respectivement compatibles avec plusieurs normes de transmission, par exemple la norme WiMAX ou WiFi.

**19.** Dispositif de conversion de fréquence d'échantillonnage d'un signal numérique échantillonné à une première fréquence d'échantillonnage, **caractérisé par le fait qu'**il comprend des moyens de réception (MR) aptes à recevoir des échantillons d'entrée du signal numérique, des moyens d'élaboration (MELB) aptes à élaborer les échantillons de sortie correspondant à une deuxième fréquence d'échantillonnage à partir des échantillons d'entrée et d'un filtre d'interpolation, la première fréquence d'échantillonnage ($F_s$) étant plus grande que la deuxième fréquence d'échantillonnage ($F_i$), et des moyens de sortie (SO1) aptes à délivrer des échantillons de sortie, les moyens d'élaboration (MELB) comprenant des moyens de calcul (MCL) aptes pour chaque échantillon d'entrée courant à calculer N contributions respectivement à partir de la valeur de cet échantillon d'entrée courant pondérée par les valeurs de N coefficients du filtre associés à cet échantillon d'entrée, ce nombre N étant fixé et identique pour tous les échantillons d'entrée quelle que soit la valeur du rapport de conversion entre les deux fréquences, et des moyens de traitement (MT) aptes pour chaque échantillon d'entrée à mettre à jour les valeurs courantes de N échantillons de sortie successifs avec les N contributions.

**20.** Dispositif selon la revendication 19, dans lequel les moyens d'élaboration (MELB) comportent en outre des moyens de contrôle aptes à autoriser la délivrance d'un échantillon de sortie dont la valeur a été mise à jour avec une contribution provenant d'un échantillon d'entrée courant si cet échantillon de sortie ne doit pas recevoir de contribution provenant de l'échantillon d'entrée suivant, la valeur effective de cet échantillon de sortie délivré étant ladite valeur mise à jour avec la contribution provenant de l'échantillon d'entrée courant.

**21.** Dispositif selon la revendication 20, dans lequel les moyens de traitement (MT) comportent
N entrées (IN1-IN3) aptes à recevoir respectivement les N contributions d'un échantillon d'entrée courant,
N additionneurs (ADD1-ADD3) possédant chacun une première entrée couplée à l'entrée correspondante des moyens de traitement et une deuxième entrée,
N multiplexeurs (MUX1-MUX3) aptes à être commandés par les moyens de commande et possédant chacun une première entrée connectée à la sortie de l'additionneur correspondant et une deuxième entrée,
une chaîne de N registres (R1-R3) possédant chacun une entrée couplée à la sortie du multiplexeur correspondant et une sortie couplée à la deuxième entrée de l'additionneur correspondant, la sortie du dernier registre de la chaîne étant couplée aux moyens de sortie et la sortie de chacun des autres registres étant couplée à la deuxième entrée du multiplexeur associé au registre suivant dans ladite chaîne,
un registre auxiliaire (RGA) contenant une donnée de valeur nulle et couplée à la deuxième entrée du multiplexeur associé au premier registre de la chaîne.

**22.** Dispositif selon l'une des revendications 19 à 21, dans lequel les moyens de réception (MR) sont aptes à recevoir les échantillons d'entrée au rythme des fronts d'un signal d'horloge (CK) ayant une fréquence égale à la première fréquence d'échantillonnage et les moyens d'élaboration sont aptes à élaborer les échantillons de sortie au rythme des fronts dudit signal d'horloge et les moyens de sortie sont aptes à délivrer les échantillons de sortie sur certains seulement des fronts du signal d'horloge.

**23.** Dispositif selon l'une des revendications 19 à 22, comprenant en outre des moyens de sélection (MSEL) aptes à sélectionner la valeur dudit rapport de conversion parmi un jeu de valeurs comportant des valeurs non entières.

**24.** Dispositif selon l'une des revendications 19 à 23, comprenant en outre des moyens de sélection (MSEL) aptes à sélectionner la valeur dudit rapport parmi un jeu de valeurs correspondant à des valeurs de deuxièmes fréquences d'échantillonnage compatibles avec plusieurs normes différentes, par exemple les normes WiMax ou WiFi.

**25.** Dispositif selon l'une des revendications 19 à 24, dans lequel la valeur du nombre N est fixée par la largeur de la réponse impulsionnelle du filtre d'interpolation.

**26.** Dispositif selon l'une des revendications 19 à 25, dans lequel la largeur de la réponse impulsionnelle du filtre d'interpolation est égale au produit de la deuxième période temporelle correspondant à la deuxième fréquence d'échantillonnage par un coefficient multiplicateur, et la valeur de N est égale à la partie entière supérieure du coefficient multiplicateur.

**27.** Dispositif selon l'une des revendications 19 à 26, dans lequel la courbe de réponse amplitude/fréquence du filtre d'interpolation présente des zéros aux fréquences multiples de ladite deuxième fréquence d'échantillonnage.

**28.** Dispositif selon la revendication 27, dans lequel la courbe de réponse amplitude/fréquence du filtre présente une forme du type produit de la fonction sinus cardinal élevée au carré par la fonction cosinus.

**29.** Dispositif selon l'une des revendications 19 à 28, dans lequel lesdits moyens de calcul (MCL) comportent des premiers moyens (NCO) aptes à déterminer la position temporelle d'un échantillon d'entrée courant par rapport aux N deuxièmes instants, dits instants temporels d'interpolation, respectivement associés aux N échantillons de sortie destinés à être mis à jour, et des deuxièmes moyens (BCL) aptes à déterminer les valeurs des N coefficients du filtre à partir de ladite position temporelle.

**30.** Dispositif selon la revendication 29, dans lequel les premiers moyens sont aptes à déterminer un intervalle temporel ($\mu_k$) entre le premier instant associé à un échantillon d'entrée courant et l'un des N instants temporels d'interpolation, et à déterminer les autres intervalles temporels entre ledit premier instant et les N-1 autres instants temporels d'interpolation à partir dudit intervalle temporel, et les valeurs des N coefficients du filtre correspondent respectivement aux valeurs de la réponse impulsionnelle du filtre à ces N intervalles temporels.

**31.** Dispositif selon la revendication 30 prise en combinaison avec la revendication 27 ou 28, dans lequel les deuxièmes moyens sont aptes à déterminer chacun des N coefficients du filtre à partir d'une fonction dudit intervalle temporel ($\mu_k$).

**32.** Dispositif selon la revendication 31, dans lequel ladite fonction comporte au moins une zone linéaire.

**33.** Dispositif selon la revendication 32, dans lequel la valeur dudit intervalle temporel varie entre 0 et 1 et les premiers moyens sont aptes à déterminer un intervalle temporel auxiliaire ($\mu'_k$) à partir de cet intervalle temporel dont la valeur est égale à celle dudit intervalle temporel rapportée dans la plage [0 ;0,25[, et les moyens de calcul comportent un seul multiplieur (ML) possédant une entrée couplée aux moyens d'entrée (MR) et une deuxième entrée couplée aux premiers moyens (NCO) pour recevoir ledit intervalle temporel auxiliaire.

**34.** Dispositif selon la revendication 33, dans lequel les moyens de calcul (MCL) comportent en outre un bloc (BCL) comportant au moins un additionneur (ADD), au moins un soustracteur (SB) et au moins un moyen de décalage de bits (SH) individuellement sélectionnables en fonction de la valeur de l'intervalle temporel ($\mu_k$).

**35.** Dispositif de traitement d'un signal analogique, comportant une entrée pour recevoir le signal analogique, un convertisseur analogique/numérique (CAN) couplé à ladite entrée et un dispositif de conversion de fréquence d'échantillonnage (DCF) selon l'une des revendications 19 à 34 dont les moyens d'entrée sont couplés à la sortie du convertisseur analogique/numérique.

**36.** Dispositif selon la revendication 35, dans lequel le convertisseur analogique/numérique (CAN) est du type delta-sigma.

**37.** Récepteur appartenant à au moins un système de communication sans fil, comportant une antenne (ANT) pour recevoir un signal incident et un dispositif de traitement selon la revendication 35 ou 36.

**38.** Récepteur selon la revendication 37, formant une plateforme de réception multi-normes.

**39.** Récepteur selon la revendication 38, capable de traiter des signaux compatibles avec la norme WiMAX ou WiFi.

## FIG.1

## FIG.2

$x_k$

détermination
$\mu_k$ — 60

$t_n , \ldots t_{n+N-1}$

détermination
$h_1 \ldots h_N$ — 61

N contributions

## FIG.6

$x_k$

30

$\otimes$ ⟵ $h_j$

Contribution

31

mise à jour
$y_n$

34

k=k+1

33

délivance
$y_n$

non ⟵ Contribution
de $x_{k+1}$
dans $y_n$
?

32

Oui

## FIG.3

## FIG.4

## FIG.5

x:0.0625
y:-0.1537   $H_i(f)=\sin_c(f/F_i)^2 \times \cos(\pi x f/(2\ F_i))$

FIG.7

FIG.8

FIG.9

## FIG.10

## FIG.11

## FIG.12

## FIG.13

## FIG.14

## FIG.15

**Europäisches Patentamt**
**European Patent Office**
**Office européen des brevets**

## RAPPORT DE RECHERCHE EUROPEENNE

Numéro de la demande

EP 08 15 1565

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 0 881 764 A (COMMQUEST TECH INC [US] IBM [US]) 2 décembre 1998 (1998-12-02) | 1-14, 16-32, 35-39 | INV. H03H17/06 |
| A | * colonne 6, ligne 34 - colonne 7, ligne 23 * <br> * colonne 9, ligne 8 - colonne 10, ligne 53 * <br> * figures 1A,4,9,10 * <br> ----- | 15,33,34 | |
| A | DE 100 15 700 A1 (UNIV DRESDEN TECH [DE] SIGNALION GMBH [DE]) 11 octobre 2001 (2001-10-11) * alinéas [0037] - [0044]; figures 6-11 * ----- | 1-39 | |
| A | RAMSTAD T A: "DIGITAL METHODS FOR CONVERSION BETWEEN ARBITRARY SAMPLING FREQUENCIES" IEEE TRANSACTIONS ON ACOUSTICS, SPEECH AND SIGNAL PROCESSING, IEEE INC. NEW YORK, USA, vol. ASSP-32, no. 3, 1 juin 1984 (1984-06-01), pages 577-591, XP002025612 ISSN: 0096-3518 * alinéas [0III], [00IV]; figures 4-9 * ----- | 1-39 | **DOMAINES TECHNIQUES RECHERCHES (IPC)** <br> H03H |

Le présent rapport a été établi pour toutes les revendications

| Lieu de la recherche | Date d'achèvement de la recherche | Examinateur |
|---|---|---|
| La Haye | 6 octobre 2008 | De La Pinta, Luis |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...................................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 08 15 1565

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-10-2008

| Document brevet cité au rapport de recherche | | Date de publication | Membre(s) de la famille de brevet(s) | | Date de publication |
|---|---|---|---|---|---|
| EP 0881764 | A | 02-12-1998 | CN | 1208298 A | 17-02-1999 |
| | | | JP | 3337424 B2 | 21-10-2002 |
| | | | JP | 11055077 A | 26-02-1999 |
| | | | JP | 2003069388 A | 07-03-2003 |
| | | | SG | 68667 A1 | 25-01-2000 |
| | | | TW | 391110 B | 21-05-2000 |
| | | | US | 6014682 A | 11-01-2000 |
| DE 10015700 | A1 | 11-10-2001 | AUCUN | | |

EPO FORM P0460

Pour tout renseignement concernant cette annexe : voir Journal Officiel de l'Office européen des brevets, No.12/82